# EUROPÄISCHE PATENTSCHRIFT

(11) **EP 4 079 007 B1**
(45) Veröffentlichungstag und Bekanntmachung des Hinweises auf die Patenterteilung: **12.03.2025**
(21) Anmeldenummer: 21701915.7
(22) Anmeldetag: 14.01.2021
(51) Int. Cl.: H04W 4/44, G08G 1/00, G06F 30/20, G08G 1/01

(54) **AUTOMATISIERTE ZUVERLÄSSIGKEITSPRÜFUNG EINER INFRASTRUKTURSEITIGEN ÜBERWACHUNGSSENSORIK**
AUTOMATED RELIABILITY TESTING OF AN INFRASTRUCTURE-MOUNTED MONITORING SENSOR SYSTEM
TEST DE FIABILITÉ AUTOMATISÉ D'UN SYSTÈME DE CAPTEUR DE SURVEILLANCE MONTÉ SUR UNE INFRASTRUCTURE

(30) Priorität: 10.03.2020 DE 102020203058
(43) Veröffentlichungstag der Anmeldung: 26.10.2022
(73) Patentinhaber: Robert Bosch GmbH, 70839 Gerlingen-Schillerhöhe (DE)
(72) Erfinder: SCHMID, Rolf, 8713 Uerikon (CH); FIEGE, Ludger, 85567 Grafing (DE)
(74) Vertreter: Bee, Joachim
(86) Internationale Anmeldenummer: PCT/EP2021/050608
(87) Internationale Veröffentlichungsnummer: WO 2021/180380

(56) Entgegenhaltungen:
- US-B1- 10 558 224

## Beschreibung

Die Erfindung betrifft eine Validierungseinrichtung, mit der eine Zuverlässigkeitsprüfung einer infrastrukturseitigen Überwachung einer Verkehrszelle ermöglicht wird. Weiterhin betrifft die Erfindung ein infrastrukturseitiges Verkehrsüberwachungssystem. Überdies betrifft die Erfindung ein autonomes Transportsystem. Weiterhin betrifft die Erfindung ein Verfahren zur Validierung einer Prüfung von Sensordaten. Zunehmend werden Verkehrssituationen mit Hilfe von Sensorik überwacht, sei es, um beispielsweise Verkehrsverstöße zu dokumentieren, oder auch, um Informationen an autonome oder teilautonome Fahrzeuge zu übermitteln, die mit Hilfe dieser Informationen ihr Bild von der eigenen Umgebung vervollständigen bzw. erweitern und auf dieser Basis taktische Entscheidungen treffen. Damit die infrastrukturseitig erfassten Informationen für das autonome Fahren genutzt werden können, müssen sie ausreichend zuverlässig sein. Um also Informationen mit genügend guter Qualität als valide Daten aufbereitet an die autonomen Fahrzeuge übergeben zu können, müssen die Daten auf Inhalt und Gültigkeit geprüft bzw. validiert werden. Um genügend zuverlässige Daten über eine Verkehrssituation zu erhalten, können zertifizierte Radar- oder Lidarsensoren genutzt werden, die allerdings sehr teuer sind. Es gibt Überwachungssysteme für Arbeitsschutzbereiche, welche einem tiefen SIL Level zuzuordnen sind. Allerdings sind diese nicht für den öffentlichen Bereich zugelassen bzw. nicht dafür zertifiziert.

Dokument US 10 558 224 B1 offenbart Verfahren, Vorrichtungen und Systeme zum Austausch von Fahrzeughindernisdaten zwischen Fahrzeugen und/oder zwischen Fahrzeugen und einem zentralen Server. Daten können von einem Fahrzeug empfangen und in ein Wahrnehmungssystem des Fahrzeugs integriert werden, beispielsweise basierend auf einem Vertrauensniveau, das mit der Gültigkeit der Daten verbunden ist.

Es besteht also die Aufgabe, ausreichend zuverlässige Überwachungsdaten zu erzeugen, die auch in sicherheitskritischen Verkehrs- und Mobilitätsanwendungen genutzt werden können.

Diese Aufgabe wird durch ein infrastrukturseitiges Verkehrsüberwachungssystem nach Anspruch 1 und ein Verfahren zur Validierung einer Prüfung von Sensordaten gemäß Patentanspruch 8 gelöst.

Die erfindungsgemäße Validierungseinrichtung weist eine Testeinheit zum Ausspielen/Einprägen von Testmustern zur Simulation von Sensordaten und eine Validierungseinheit auf. Ein solches Testmuster umfasst nachgebildete korrekte und fehlerhafte Sensordaten.

Die Validierungseinheit umfasst weiterhin eine Fusionsdatenschnittstelle zum Empfangen von fusionierten Sensordaten. Fusionierte Sensordaten sind Daten, welche auf Basis von mindestens zwei unterschiedlichen Sensoren erzeugt werden. Beispielsweise kann es sich dabei um eine Kombination von Sensordaten von Radarsensoren und Lidarsensoren handeln. Die erfindungsgemäße Validierungseinrichtung umfasst auch eine Prüfdatenschnittstelle zum Empfangen von Prüfergebnissen, welche auf Basis der fusionierten simulierten Sensordaten erzeugt werden. Die möglicherweise fehlerhaften fusionierten Sensordaten werden auf unterschiedliche Weise auf Konsistenz geprüft, um fehlerhafte Funktionsblöcke und Daten schnell zu erkennen. Wird nun eine fehlende Konsistenz der Daten bei der Prüfung erkannt, so werden die Sensordaten als fehlerhaft eingestuft.

Um nun ein korrektes Funktionieren dieser Fehlerüberwachung sicherzustellen bzw. nachzuweisen oder gegebenenfalls eine unzureichende Fehlerüberwachung zu erkennen, werden über eine Testmusterschnittstelle die ausgespielten Testmuster von der Testeinheit empfangen und es wird eine Validität der Prüfergebnisse auf Basis eines Vergleichs mit diesen Testmustern ermittelt. Vorteilhaft können infrastrukturseitige erfasste und gegebenenfalls bereits aufbereitete und ausgewertete Sensordaten bzw. Objektdaten auf ihre Verfälschung und Zuverlässigkeit geprüft werden. Einem autonom gesteuerten Fahrzeug kann dann zusammen mit den genannten Sensordaten und Objektdaten eine Information über die Zuverlässigkeit dieser Daten mitgeteilt werden. Beispielsweise kann eine sogenannte Sicherheitsanforderungsstufe ermittelt werden und das Verhalten des Fahrzeugs an die aktuelle Sicherheitsanforderungsstufe angepasst werden. Vorteilhaft wird eine erhöhte Sicherheit des autonomen Fahrens erreicht.

Das erfindungsgemäße infrastrukturseitige Verkehrsüberwachungssystem umfasst eine Mehrzahl von Sensoreinheiten zur Erfassung von Sensordaten von einer Verkehrszelle, eine Sensorfusionseinheit zur Fusion der erfassten Sensordaten, eine Prüfeinrichtung zur Prüfung der Korrektheit der Sensordaten und eine erfindungsgemäße Validierungseinrichtung. Vorteilhaft werden mit Hilfe des erfindungsgemäßen infrastrukturseitigen Verkehrsüberwachungssystems zuverlässige Objektdaten erzeugt, auf deren Basis autonom gesteuerte Fahrzeuge eine Fahrtaktik planen können.

Das erfindungsgemäße autonome Transportsystem weist mindestens ein zumindest teilautonom gesteuertes Fahrzeug und ein infrastrukturseitiges Verkehrs- bzw. Objektüberwachungssystem auf. Das zumindest teilautonom gesteuerte Fahrzeug ist dazu eingerichtet, von dem infrastrukturseitigen Verkehrsüberwachungssystem erzeugte fusionierte Sensordaten, Prüfdaten sowie Validierungsdaten zu empfangen und auf Basis dieser Daten eine zumindest teilautonome Steuerung durchzuführen. Das erfindungsgemäße autonome Transportsystem teilt die Vorteile des infrastrukturseitigen Verkehrsüberwachungssystems.

Bei dem erfindungsgemäßen Verfahren zur Validierung einer Prüfung von Sensordaten werden zur Simulation von Sensordaten Testmuster ausgespielt, es werden fusionierte simulierte Sensordaten empfangen. Weiterhin werden Prüfergebnisse empfangen, welche auf Basis der fusionierten simulierten Sensordaten erzeugt werden. Außerdem werden die ausgespielten Testmuster als Referenzdaten empfangen. Schließlich wird eine Validität der Prüfergebnisse auf Basis eines Vergleichs der Prüfergebnisse mit den Testmustern ermittelt. Das erfindungsgemäße Verfahren teilt die Vorteile der erfindungsgemäßen Validierungseinrichtung.

Einige Komponenten der erfindungsgemäßen Validierungseinrichtung, des erfindungsgemäßen infrastrukturseitigen Verkehrsüberwachungssystems und des erfindungsgemäßen autonomen Transportsystems können zum überwiegenden Teil in Form von Softwarekomponenten ausgebildet sein. Dies betrifft insbesondere Teile der Testeinheit, der Prüfungseinheit und der Validierungseinheit. Grundsätzlich können diese Komponenten aber auch zum Teil, insbesondere wenn es um besonders schnelle Berechnungen geht, in Form von softwareunterstützter Hardware, beispielsweise FPGAs oder dergleichen, realisiert sein. Ebenso können die benötigten Schnittstellen, beispielsweise wenn es nur um eine Übernahme von Daten aus anderen Softwarekomponenten geht, als Softwareschnittstellen ausgebildet sein. Sie können aber auch als hardwaremäßig aufgebaute Schnittstellen ausgebildet sein, die durch geeignete Software angesteuert werden.

Eine weitgehend softwaremäßige Realisierung hat den Vorteil, dass auch schon bisher in einem autonomen Transportsystem vorhandene Rechnersysteme nach einer eventuellen Ergänzung durch zusätzliche Hardwareelemente auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung eines solchen Transportsystems ladbar ist, mit Programmabschnitten, um die durch Software realisierbaren Schritte des erfindungsgemäßen Verfahrens auszuführen, wenn das Computerprogramm in dem Transportsystem ausgeführt wird.

Ein solches Computerprogrammprodukt kann neben dem Computerprogramm gegebenenfalls zusätzliche Bestandteile, wie z.B. eine Dokumentation und/oder zusätzliche Komponenten, auch Hardware-Komponenten, wie z.B. Hardware-Schlüssel (Dongles etc.) zur Nutzung der Software, umfassen.

Zum Transport zur Speichereinrichtung des Rechnersystems und/oder zur Speicherung an dem Rechnersystem kann ein computerlesbares Medium, beispielsweise ein Memorystick, eine Festplatte oder ein sonstiger transportabler oder fest eingebauter Datenträger dienen, auf welchem die von einer Rechnereinheit einlesbaren und ausführbaren Programmabschnitte des Computerprogramms gespeichert sind. Die Rechnereinheit kann z.B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie und deren Beschreibungsteilen weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

In einer Ausgestaltung der erfindungsgemäßen Validierungseinrichtung weist die Validierungseinheit eine Lichtsignaldatenschnittstelle zum Empfangen von Signaldaten von einer Lichtsignaleinheit auf. Die möglichen Signalzustände der Signalampel wie z.B. Rot, Gelb und Grün können in der Validierungseinheit durch ein Abfolgeprüffenster auf Plausibilität geprüft werden.

In einer Ausgestaltung des erfindungsgemäßen infrastrukturseitigen Verkehrsüberwachungssystems umfasst die Prüfeinrichtung mindestens eine der folgenden Prüfeinheiten:
- eine Redundanzprüfungseinheit zum Prüfen, ob Objekte mit unterschiedlichen Sensoren mit einer vordefinierten zeitlichen und örtlichen Toleranz detektiert werden,
- eine Abfolgeprüfungseinheit zum Prüfen, ob eine detektierte Bewegung konform mit vorbestimmten Kriterien verläuft,
- eine Abschattungsprüfungseinheit zum Prüfen, ob ein detektiertes Objekt durch ein anderes Objekt abgeschattet wird.

Bei der Redundanzprüfung werden von unterschiedlichen Sensoren erzeugte Sensordaten gegeneinander verglichen. Ergeben sich Widersprüche zwischen den Daten, so wird eine Fehlerwarnung ausgegeben. Die Abfolgeprüfungseinheit prüft zum Beispiel, ob das Bewegungsverhalten von detektierten Objekten den physikalischen Gesetzen entspricht. Führt ein Objekt in einem Überwachungsfeld zum Beispiel größere Sprünge durch, so kann von einer fehlerhaften Detektion ausgegangen werden. Mit Hilfe der Abschattungsprüfung werden typische scheinbare Fehler erkannt, die sich aus einer gegebenen Sensorinstallation ergeben. Damit können falsche Fehlermeldungen verhindert werden, wodurch die Effizienz der Fehleroffenbarung erhöht wird.

In einer Variante des erfindungsgemäßen infrastrukturseitigen Verkehrsüberwachungssystems umfasst die Prüfungseinrichtung eine Parametrisierungseinheit, welche dazu eingerichtet ist, Prüfparameter der Prüfeinheiten bereitzustellen. Die Prüfparameter können zum Beispiel Informationen über Toleranzen und einen Fangbereich enthalten. Die Parameter können nach dem Schreiben auf Inhalt und Verfälschung geprüft werden. Auf diese Weise lässt sich die Zuverlässigkeit des Prüfvorgangs überwachen.

In einer Ausgestaltung des erfindungsgemäßen infrastrukturseitigen Verkehrsüberwachungssystems umfasst die Testeinheit ferner einen Drehspiegel, welcher dazu eingerichtet ist, ein von der Testeinheit erzeugtes Testmuster auf die Sensoren zu reflektieren bzw. zu projizieren. Vorteilhaft können mit Hilfe des Drehspiegels Sensoren selbst auf ihre Funktion geprüft werden. Werden die Testmuster von einem Sensor während eines projektierten Zeitfensters nicht erfasst, so wird dieser Sensor als fehlerhaft eingestuft und gemeldet.

Bevorzugt umfasst die Testeinheit des erfindungsgemäßen infrastrukturseitigen Verkehrsüberwachungssystems eine virtuelle Sensoreinheit, welche dazu eingerichtet ist, auf Basis eines Testmusters virtuelle Sensordaten zu erzeugen und der Prüfeinrichtung und der Validierungseinrichtung bereitzustellen. Vorteilhaft kann die Prüfeinrichtung sowie die Sensorfusionseinrichtung sowie die Validierungseinrichtung getrennt von den eigentlichen Sensoren getestet werden, so dass die Funktionalität einzelner Einheiten ermittelt werden kann und Fehler lokalisiert werden können.

Das erfindungsgemäße autonome Transportsystem umfasst vorzugsweise mindestens eine Lichtsignalanlageneinheit, welche mit dem infrastrukturseitigen Verkehrsüberwachungssystem über einen Kommunikationskanal verbunden ist und dazu eingerichtet ist, dem infrastrukturseitigen Verkehrsüberwachungssystem Informationen über den aktuellen Signalzustand der Lichtsignalanlageneinheit zu übermitteln. Vorteilhaft kann eine Gefahrensituation, die sich beispielsweise durch das Überfahren eines Lichtsignals ergibt, erkannt werden und bei der Fahrtaktikplanung eines autonomen Fahrzeugs mitberücksichtigt werden.

Die Erfindung wird im Folgenden unter Hinweis auf die beigefügten Figuren anhand von Ausführungsbeispielen noch einmal näher erläutert. Es zeigen:
FIG 1 eine schematische Darstellung eines Verkehrsszenarios mit infrastrukturseitigen Sensoren zur Überwachung der Verkehrssituation,
FIG 2 eine schematische Darstellung eines infrastrukturgebundenen Verkehrsüberwachungssystems mit einer Validierungseinrichtung gemäß einem Ausführungsbeispiel der Erfindung,
FIG 3 eine schematische Darstellung eines infrastrukturgebundenen Verkehrsüberwachungssystems mit einer Validierungseinrichtung gemäß einem zweiten Ausführungsbeispiel der Erfindung,
FIG 4 eine schematische Darstellung eines autonomen Transportsystems gemäß einem Ausführungsbeispiel der Erfindung,
FIG 5 eine schematische Darstellung eines infrastrukturgebundenen Verkehrsüberwachungssystems mit einer Validierungseinrichtung gemäß einem dritten Ausführungsbeispiel der Erfindung,
FIG 6 ein Flussdiagramm, welches ein Validierungsverfahren gemäß einem Ausführungsbeispiel der Erfindung veranschaulicht,
FIG 7 ein Schaubild, welches den Verlauf der Verlässlichkeit der übermittelten Sensordaten und die zugehörige erreichte Sicherheitsanforderungsstufe anzeigt.

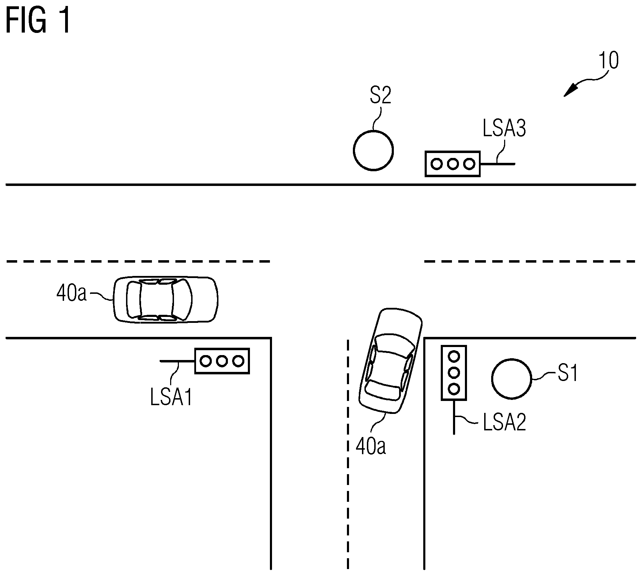

In FIG 1 ist ein Verkehrsszenario 10 mit infrastrukturseitigen Sensoren S1, S2 zur Überwachung der Verkehrssituation veranschaulicht. Das Verkehrsszenario 10 umfasst eine Einmündung, wobei an allen drei Zufahrten zur Einmündung jeweils eine Lichtsignalanlage LSA1, LSA2, LSA3 angeordnet ist. Im Einmündungsbereich sind auch zwei Sensoren S1, S2 positioniert, von denen ein erster Sensor S1 ein Radarsystem umfasst und ein zweiter Sensor S2 ein Lidarsystem umfasst, und welche den Einmündungsbereich überwachen. In dem Einmündungsbereich befinden sich auch zwei Kraftfahrzeuge 40a, von denen ein erstes Fahrzeug in der linken Bildhälfte vor einer Lichtsignalanlage LSA1 hält und ein zweites Fahrzeug 40a gerade nach rechts abbiegt. Der von den beiden Sensoren S1, S2 überwachte Bereich kann auch als Verkehrszelle bezeichnet werden.

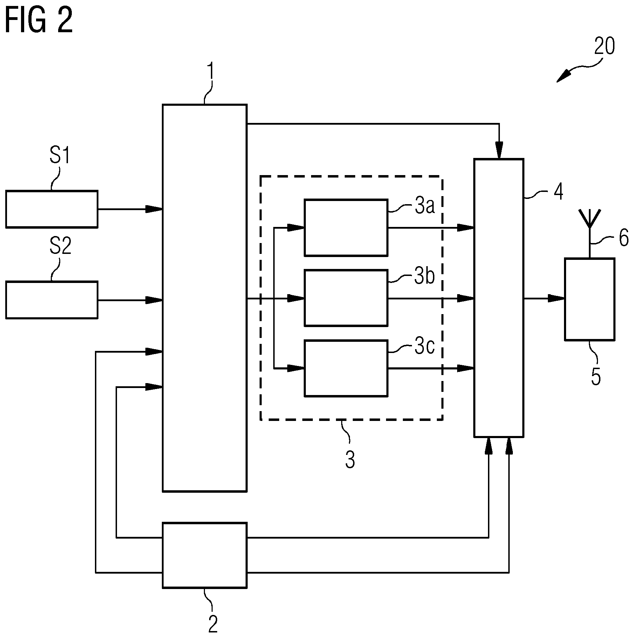

In FIG 2 ist ein infrastrukturgebundenes Verkehrsüberwachungssystem 20 mit einer Validierungseinrichtung 4 gemäß einem Ausführungsbeispiel der Erfindung gezeigt. Das infrastrukturgebundene Verkehrsüberwachungssystem 20 weist einen Radarsensor S1 und einen Lidarsensor S2 auf, mit denen eine Verkehrszelle (siehe FIG 1) überwacht wird. Die Sensoren S1, S2 liefern Sensordaten, die an eine Sensordatenfusionseinheit 1 übermittelt werden. Die Sensordatenfusionseinheit 1 fügt die Sensordaten von mehreren Sensoren zu einem einheitlichen Sensordatensatz zusammen. Dieser umfasst zum Beispiel die Information, dass sich in einem Überwachungsbereich ein oder mehrere Objekte befinden, an welcher Stelle des Überwachungsbereichs sich diese Objekte befinden und welchen Typs diese Objekte sind. Die fusionierten Sensordaten werden als Referenzdaten direkt an eine Validierungseinrichtung 4 übermittelt.

Weiterhin erfolgt auf Basis der fusionierten Sensordaten durch eine Prüfeinrichtung 3 eine Konsistenzprüfung der Sensordaten. Hierfür weist die Prüfeinrichtung 3 eine Redundanzprüfeinheit 3a auf. Die Redundanzprüfeinheit 3a ist dazu eingerichtet, zu prüfen, ob die mit Hilfe der Sensoren S1, S2 detektierten Objekte auf beiden Kanälen der Sensoren S1, S2 mit einer vordefinierten zeitlichen und örtlichen Toleranz detektiert werden. Wird ermittelt, dass die vordefinierte Toleranz verletzt ist, so wird nach dem Verlassen eines sogenannten Überwachungsprüfzeitfensters ein sogenannter "degradierter Modus" (Erhaltungsmodus/Rückfallmodus) als Betriebsmodus für das Verkehrsüberwachungssystem 20 ausgelöst. In diesem degradierten Modus sind die Überwachungsdaten weniger zuverlässig und werden daher nicht oder nur im Fail Safe Prinzip bzw. nach dem Prinzip der Ausfallsicherheit (ein Beispiel ist ein Unfall-Nothalt für alle Straßenverkehrsteilnehmer) weiter an in der Nähe befindliche Fahrzeuge weitergeleitet. Erst nach einem vordefinierten Zeitfenster wird der degradierte Modus wieder verlassen. Je nach der Komplexität der Verkehrssituation können mehrere degradierte Modi projektiert werden.

Außerdem weist die Prüfeinrichtung 3 eine Abfolgeprüfungseinheit 3b auf. Die Abfolgeprüfungseinheit 3b prüft auf Basis der von den Sensoren S1, S2 erfassten Sensordaten, ob die Bewegungsvektoren von detektierten Objekten konsistent sind. Wird festgestellt, dass eine Bewegungsabfolge von detektierten Objekten physikalischen Gesetzen widerspricht, so wird nach dem Verlassen eines Zeitfensters ebenfalls der degradierte Modus als Betriebsmodus gewählt. Erst nach einem vordefinierten Zeitfenster wird der degradierte Modus wieder verlassen.

Teil der Prüfeinrichtung 3 ist auch eine Abschattungsprüfungseinheit 3c. Die Abschattungsprüfungseinheit 3c prüft, ob ein Objekt durch ein anderes Objekt abgeschattet ist. Beispielsweise wird festgestellt, dass ein detektiertes Objekt nur durch einen Sensor S1 der beiden Sensoren S1, S2 erkannt wurde. Weiterhin wird möglicherweise ein weiteres Objekt detektiert, welches zwischen dem Sensor S2, der das Objekt nicht detektiert hat, und diesem Objekt liegt. Wird eine Abschattung ermittelt, so wird wiederum ein Überwachungszeitfenster aktiviert. Bei dem Verlassen des Überwachungszeitfensters wird wieder der degradierte Modus als Betriebsmodus ausgelöst. Erst nach einer vordefinierten Zeitdauer wird der degradierte Modus wieder verlassen.

Zur Prüfung, ob die von den Prüfeinheiten 3a, 3b, 3c ermittelten Betriebsmodi auch korrekt sind, wird neben der Validierungseinrichtung 4 auch eine Testeinheit 2 eingesetzt. Die Testeinheit 2 erzeugt ein Prüfmuster, welches simulierte Sensordaten umfasst. Die vorgerechneten bzw. simulierten Sensordaten werden an die Sensordatenfusionseinheit 1 übermittelt, welche daraus einen einheitlichen Sensordatensatz zusammenfügt. Der einheitliche Sensordatensatz wird dann an die Prüfungseinrichtung 3 übermittelt, welche die simulierten Daten auf die bereits beschriebene Art und Weise verarbeitet. Außerdem werden die Prüfmuster mit den bereits bekannten Prüfergebnissen als Referenzdaten von der Testeinheit 2 direkt an die Validierungseinrichtung 4 gesendet. Erhält nun die Validierungseinrichtung 4 von der Prüfungseinrichtung 3 Prüfdaten sowie von der Fusionseinheit 1 fusionierte Sensordaten, so kann die Validierungseinrichtung 4 durch einen Vergleich mit den Referenzdaten ermitteln, ob die Prüfeinrichtung 3 sowie die Fusionseinheit 2 korrekt funktionieren. Anschließend kann über die Kommunikationseinheit 5, welche eine Antenne 6 umfasst, eine Mitteilung an in der Nähe befindliche Fahrzeuge darüber gegeben werden, wie zuverlässig die übermittelten Informationen sind, einschließlich der Angaben zu dem aktuellen Betriebsmodus.

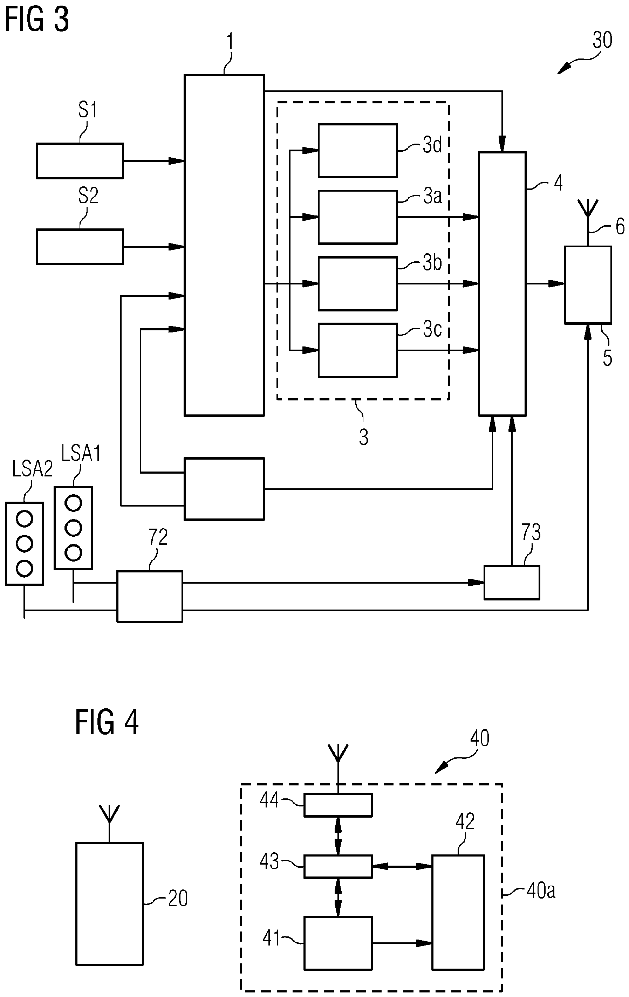

In FIG 3 ist ein infrastrukturgebundenes Verkehrsüberwachungssystem 30 gemäß einem zweiten Ausführungsbeispiel der Erfindung gezeigt. Das in FIG 3 gezeigte infrastrukturgebundene Verkehrsüberwachungssystem 30 weist ähnlich wie das in FIG 2 gezeigte Verkehrsüberwachungssystem 20 mehrere Sensoren S1, S2, eine Sensorfusionseinheit 1, eine Testeinheit 2, eine Prüfeinrichtung 3, eine Validierungseinrichtung 4 und eine Kommunikationseinheit 5 auf. Zusätzlich umfasst das in FIG 3 gezeigte infrastrukturgebundenes Verkehrsüberwachungssystem 30 mehrere Lichtsignalanlagen LSA1, LSA2, welche über eine Kommunikationsleitung mit einer Steuerungseinheit 72, einer Dekodereinheit 73 und mit der Validierungseinrichtung 4 sind. Die Lichtsignalanlagen LSA1, LSA2 übermitteln an die Validierungseinrichtung 4 Informationen über ihren Zustand, beispielsweise, welches Signal sie anzeigen, d.h. ob sie gerade rot, grün oder gelb anzeigen. Der LSA-Decoder 73 bereitet die Signaldaten für den Fahrweg eines Fahrzeugs auf. Dabei prüft der Decoder 73 die rudimentäre Abfolge der Signale. Eine einfache Plausibilitätsprüfung ermöglicht einen ausfallsicheren Modus oder einen degradierten Modus.

Die in FIG 3 gezeigte Prüfeinrichtung 3 umfasst außerdem zusätzlich zu den bereits in FIG 2 gezeigten Prüfeinheiten 3a, 3b, 3c eine Landmarkenprüfeinheit 3d. Die Landmarkenprüfeinheit prüft, ob die dem Verkehrsüberwachungssystem 30 zugeordneten Sensoren, wie zum Beispiel der Radarsensor S1 und der Lidarsensor S2, noch funktionieren bzw. sich zumindest noch an ihrem vorgesehenen Platz befinden. Die Signaldaten werden ebenfalls in die Validierung der Sensordaten und der Prüfinformationen miteinbezogen. Die Signaldaten werden mit einem virtuellen Objekt oder Prüfmuster verknüpft und einem in der Nähe befindlichen Straßenfahrzeug zur Anzeige einer Gefahrenstelle übermittelt.

In FIG 4 ist ein autonomes Transportsystem 40 gemäß einem Ausführungsbeispiel der Erfindung schematisch dargestellt. Das autonome Transportsystem 40 umfasst das in FIG 2 gezeigte infrastrukturseitige Verkehrsüberwachungssystem 20 sowie ein Fahrzeug 40a, welches die von dem infrastrukturseitige Verkehrsüberwachungssystem 20 erfassten Sensordaten per Funk übermittelt bekommt. Das Fahrzeug 40a umfasst ebenfalls eine Testeinheit 41, mit der Testmuster über einen sogenannten CRC-Black Channel 43 sowie eine RSU-Funkeinheit 44 an das infrastrukturseitige Verkehrsüberwachungssystem 20 übermittelt werden können. Die Testeinheit 41 kann zusätzlich auch eine sogenannte Rückkanalprüfung durchführen, bei der dem infrastrukturseitigen Verkehrsüberwachungssystem 20 eine aus den Objektlisten gerechnete CRC bereitgestellt wird. Teil der Testeinheit 41 ist auch ein Diagnoseadapter, welcher alle Resultate der Prüfungen, wie zum Beispiel die Ergebnisse der Redundanzprüfung, der Abfolgeprüfung und der Abschattungsprüfung speichert. Teil der Testeinheit 41 ist auch ein sogenannter Ladeadapter, welcher Prüfprozesse für Testparameter durchführt. Beispielsweise werden ein Zutrittsschutz und eine Verfälschungsprüfung implementiert. Teil des Fahrzeugs 40a ist auch ein sogenannter AD-Stack 42. Der AD-STACK verarbeitetet die von der Infrastruktur aufbereiten Daten, damit die zyklische Fahrwegprüfung abgeschlossen werden kann. Bei positiver Fahrwegprüfung wird kein Bremsmanöver vom Fahrzeug initiiert. Bei negativer Fahrwegprüfung wird dagegen eine der im AD-Stack hinterlegten Bremskurven ausgeführt.

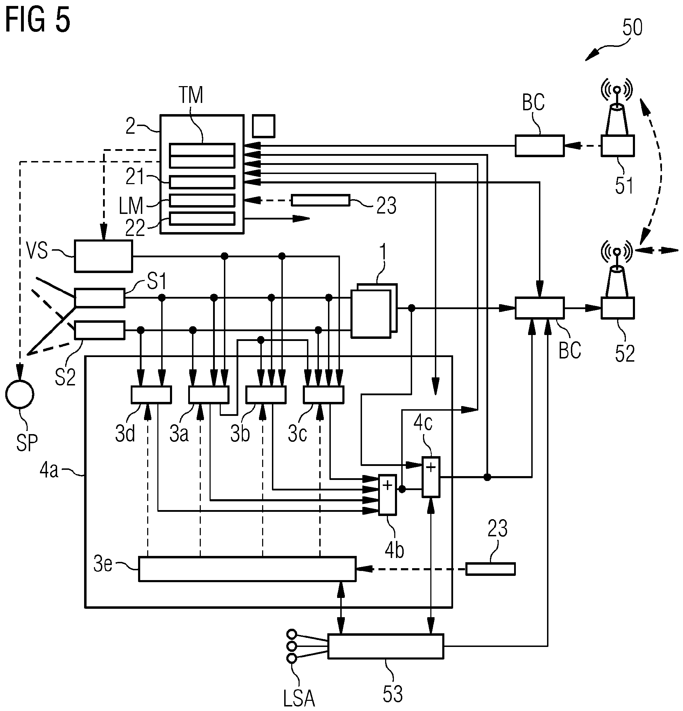

In FIG 5 ist ein infrastrukturgebundenes Verkehrsüberwachungssystem 50 mit einer Validierungseinrichtung gemäß einem dritten Ausführungsbeispiel der Erfindung gezeigt. Das in FIG 5 veranschaulichte infrastrukturgebundene Verkehrsüberwachungssystem 50 umfasst ähnlich wie die in FIG 2 und FIG 3 veranschaulichten Systeme 20, 30 zwei Sensoren S1, S2. Zusätzlich umfasst das infrastrukturgebundene Verkehrsüberwachungssystem 50 auch einen virtuellen Sensor VS, welcher durch ein Testmuster, das von einer Testeinheit 2 erzeugt wird, simuliert wird. Die Testeinheit 2 erzeugt auch ein Testmuster TM, welches mit Hilfe eines Spiegels SP an die Sensoren S1, S2 übermittelt wird und von diesen an die Sensorfusionseinheit 1 und die Prüfeinheiten 3a, 3b, 3c, 3d übermittelt wird. Die Prüfeinheiten 3a, 3b, 3c, 3d sind in dem in FIG 5 gezeigten Ausführungsbeispiel Teil einer Prüf- und-Validierungseinheit 4a. Mit Hilfe der Prüfeinheiten 3a, 3b, 3c, 3d kann neben der Redundanzprüfung, der Abfolgeprüfung und der Abschattungsprüfung auch eine Prüfung von Landmarken LM erfolgen. Sind nämlich die Sensoren defekt, so wird bei der Landmarkenprüfung kein Testmuster an die Prüfeinheiten 3a, 3b, 3c weitergegeben, was in diesem Fall auf defekte Sensoren S1, S2 schließen lässt. Teil der Prüfeinheiten ist auch eine Parametrierungseinheit 3e, welche Testparameter, wie zum Beispiel einen Fangbereich oder Toleranzen festlegt. Der Fangbereich kann als geographisches Filter angesehen werden. Der Fangbereich der Verkehrssituation wird so gesetzt, dass nur die notwendigen Informationen für die Sicherheitsbeurteilung des Fahrweges herangezogen werden. Dies macht die Applikation besonders robust gegenüber Fremdeinflüssen.

Der Zugang zur Parametrierungseinheit 3e wird von einem Ladeadapter 23 kontrolliert, welcher einen Zutrittschutz und eine Verfälschungsprüfung bereitstellt. Teil der Prüf-und-Validierungseinheit 4a ist auch eine Validierungseinheit 4b, welche sowohl die Prüfergebnisse von den Prüfeinheiten 3a, 3b, 3c, 3d empfängt, als auch diese Prüfergebnisse mit den fusionierten Sensordaten von der Sensorfusionseinheit 1 und den Testmustern von der Testeinheit 2 vergleicht. Die Validierungsergebnisse, und die Prüfungsergebnisse werden an eine Datenkombinationseinheit 4c übermittelt, die noch zusätzlich Zustandsdaten von einer Lichtsignalanlage LSA erhält. Die Zustandsdaten, die Validierungsergebnisse, die Prüfungsergebnisse sowie die Sensordaten von der Sensorfusionseinheit 1 werden dann über einen sogenannten CRC-Black-Channel BC an eine Funkeinheit 52 übermittelt, von der sie zum Beispiel an ein autonomes Fahrzeug 40a übermittelt werden. Außerdem werden die genannten Zustandsdaten, die Validierungsergebnisse, die Prüfungsergebnisse sowie die Sensordaten über den CRC-Black-Channel BD auch an die Testeinheit 2 übermittelt. "CRC" steht hier für eine zyklische Redundanzprüfung der übertragenen Daten (CRC = cyclic redundancy check). Dabei wird ein Prüfwert ermittelt, um Fehler bei der Übertragung oder Speicherung zu erkennen. Die Testeinheit 2 umfasst auch einen Diagnoseadapter 22, mit dem alle Resultate der Abfolgeprüfung, der Redundanzprüfung und der Abschattungsprüfung gespeichert werden. Weiterhin umfasst die Testeinheit 2 auch eine Rückkanalprüfungseinheit 21, mit der der Infrastruktur ein aus Objektlisten gerechneter CRC-Wert zugesendet wird. Die Testeinheit 2 kann auch direkt über einen Black-Channel BC und eine weitere Funkeinheit 51 mit der Testeinheit eines Fahrzeugs (nicht gezeigt) kommunizieren. Die Testeinheit 2 steht auch mit einem sogenannten Ladeadapter 23 in Verbindung, welcher für den Zugang zur Parametrisierung der Testmuster benötigt wird. Mit Hilfe des Ladeadapters 23 wird ein Zutrittschutz sowie eine Verfälschungsprüfung bereitgestellt.

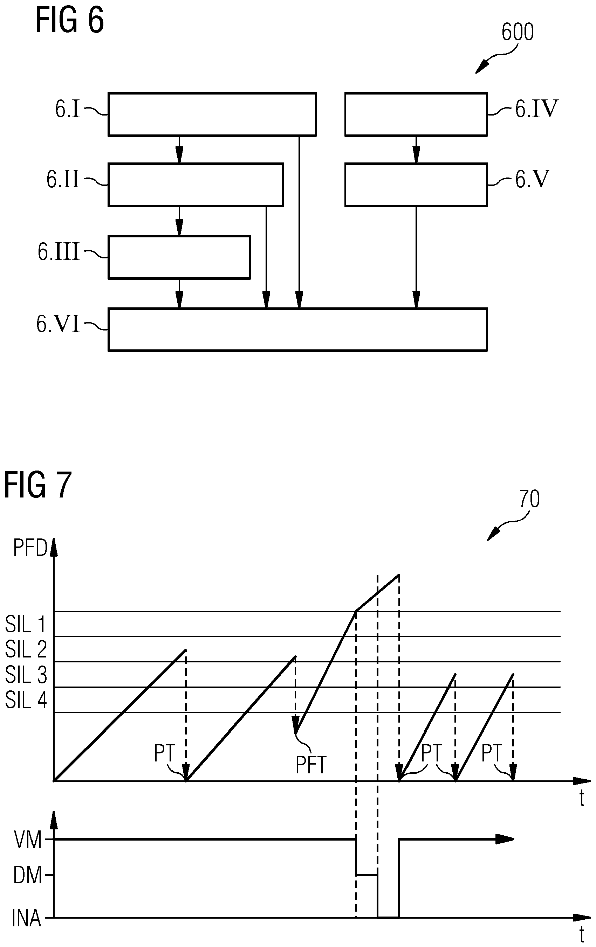

In FIG 6 ist ein Flussdiagramm 600 gezeigt, welches ein Validierungsverfahren gemäß einem Ausführungsbeispiel der Erfindung veranschaulicht. Bei dem Schritt 6.I erfolgt zunächst ein Ausspielen eines Testmusters für Sensoren einer Verkehrszelle durch eine Testeinheit 2. Die virtuellen Sensordaten des Testmusters werden bei dem Schritt 6.II fusioniert und an die Prüfeinheit 3 und gleichzeitig an die Validierungseinrichtung 4 übermittelt. Bei dem Schritt 6.III führt die Prüfeinheit 3 eine Reihe von Prüfungen der fusionierten Daten, wie zum Beispiel eine Redundanzprüfung, eine Abfolgeprüfung und eine Abschattungsprüfung, durch.

Bei dem Schritt 6.IV werden Lichtsignaldaten von mehreren Lichtsignalanlagen einer Verkehrszelle erfasst. Diese Lichtsignaldaten werden bei dem Schritt 6.V dekodiert und an die Validierungseinrichtung 4 übermittelt. Der Decoder bereitet die Signaldaten für den Fahrweg eines Fahrzeugs auf. Dabei wird eine rudimentäre Abfolge geprüft. Über eine einfache Plausibilitätsprüfung wird ermittelt, ob eine Gefahr besteht oder ein degradierter Modus ausgelöst werden muss.

Schließlich erfolgt bei dem Schritt 6.VI eine Validierung der empfangenen Prüfungsdaten, der fusionierten Sensordaten und der Signaldaten. Dabei erfolgt ein Vergleich der bekannten Testmuster mit einem vorprojektierten Zeitfenster sowohl mit den Fusionsergebnissen aus dem Schritt 6.II als auch den Prüfungsergebnissen aus dem Schritt 6.III. Die Lichtsignaldaten aus den Schritten 6.IV und 6.V werden ebenfalls zur Validierung herangezogen. Beispielsweise kann dadurch eine Gefahrensituation erkannt werden und gegebenenfalls ein degradierter Modus ausgelöst werden.

In FIG 7 ist ein Schaubild 70 gezeigt, welches in seinem oberen Teilschaubild den Verlauf der Verlässlichkeit PFD der übermittelten Sensordaten und die zugehörige erreichte Sicherheitsanforderungsstufe SIL anzeigt. Beispielsweise sind die Daten nach einer Validierung bei t = 0s vollständig validiert bzw. sicher, was mit dem PFD-Wert = 0 gekennzeichnet ist. Im unteren Teilschaubild entspricht diese maximale Sicherheit dem validierten Modus VM, was ja der Tatsache Rechnung trägt, dass zu dem Zeitpunkt t = 0 eine erfolgreiche Validierung durchgeführt wurde. Anschließend verschlechtert sich die Zuverlässigkeitsprognose der Sensordaten linear oder exponentiell mit der Zeit bis zur Sicherheitsanforderungsstufe SIL 2, bis wiederum eine erfolgreiche Validierungsprüfung PT durchgeführt wird und die Zuverlässigkeitsprüfungen der Sensordaten sowie der durchgeführten Prüfungen wieder fehlerfrei vollzogen sind. Ergibt nun eine Validierung PTF, dass die erfassten Daten teilweise verfälscht sind oder fehlen, so verschlechtert sich die Zuverlässigkeit der Funktionalität. Anschließend ergibt sich eine rapide Verschlechterung der Zuverlässigkeitsprognose, so dass die Sicherheitsanforderungsstufe SIL1 nicht mehr erreicht wird. Zu diesem Zeitpunkt, der in den beiden Teilschaubildern mit einer vertikalen gestrichelten Linie gekennzeichnet ist, wird in den degradierten Modus DM geschaltet. In diesem Modus nutzen Fahrzeuge die neu übermittelten Sensordaten nicht mehr vollumfänglich für die Fahrwegsicherung oder nur eingeschränkt. Nach einer vorbestimmten Zeitspanne erfolgt aufgrund der weiter steigenden Unzuverlässigkeit der übermittelten infrastrukturseitigen Daten dann sogar ein vollständiges gezieltes Abschalten der Übertragung von Sensordaten von der Infrastruktur. Dieser Zustand wird in dem unteren Teilschaubild durch einen Modus INA auf der untersten Stufe dargestellt. Erfolgt anschließend eine erfolgreiche Validierung PT, so steigt die Zuverlässigkeit der infrastrukturseitig übermittelten Daten auf einen Maximalwert und der validierte Modus VM wird wieder erreicht. Die Abfolge der Validierung kann in Zeitabständen von 50 ms bis 10 s erfolgen. Die zeitliche Dauer einer Validierung bzw. Validierungsprüfung wird dabei parametrisiert und ist abhängig von der Verkehrssituation.

Es wird abschließend noch einmal darauf hingewiesen, dass es sich bei den vorbeschriebenen Verfahren und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. Infrastrukturseitiges Verkehrsüberwachungssystem (20, 30, 50), aufweisend:
- eine Mehrzahl von Sensoreinheiten (S1, S2) zur Erfassung von Sensordaten von einer Verkehrszelle (10),
- eine Sensorfusionseinheit (1) zur Fusion von Sensordaten,
- eine Prüfeinrichtung (3) zur Prüfung der Korrektheit von fusionierten Sensordaten, wobei die Prüfeinrichtung (3) ausgebildet ist, fusionierte Sensordaten von der Sensorfusionseinheit (1) zu empfangen und auf Basis der fusionierten Sensordaten eine Konsistenzprüfung der Sensordaten durchzuführen und Prüfergebnisse auszugeben, wobei die Prüfeinrichtung (3) mindestens eine der folgenden Prüfeinheiten umfasst:
- eine Redundanzprüfungseinheit (3a) zum Prüfen, ob Objekte mit unterschiedlichen Sensoren mit einer vordefinierten zeitlichen und örtlichen Toleranz detektiert werden,
- eine Abfolgeprüfungseinheit (3b) zum Prüfen, ob eine detektierte Bewegung konform mit vorbestimmten Kriterien verläuft,
- eine Abschattungsprüfungseinheit (3c) zum Prüfen, ob ein detektiertes Objekt durch ein anderes Objekt abgeschattet wird,
- eine Validierungseinrichtung, aufweisend:
- eine Testeinheit (2) zum Ausspielen von Testmustern (TM) zur Simulation von Sensordaten, wobei ein Testmuster simulierte Sensordaten umfasst,- eine Validierungseinheit (4) mit
- einer Fusionsdatenschnittstelle zum Empfangen von fusionierten simulierten Sensordaten von der Sensorfusionseinheit (1),
- einer Prüfdatenschnittstelle zum Empfangen von Prüfergebnissen, welche auf Basis der fusionierten simulierten Sensordaten von der Prüfeinrichtung (3) erzeugt werden,
- einer Testmusterschnittstelle zum Empfangen der ausgespielten Testmuster (TM) von der Testeinheit (2),
wobei die Testeinheit (2) ausgebildet ist, die simulierten Sensordaten an die Sensorfusionseinheit (1) zu übermitteln, welche dazu eingerichtet ist, daraus fusionierte simulierte Sensordaten zu erzeugen und an die Prüfungseinrichtung (3) zu übermitteln, welche dazu eingerichtet ist, die fusionierten simulierten Sensordaten zu verarbeiten und zugehörige Prüfergebnisse zu erzeugen,
wobei die Validierungseinrichtung dazu eingerichtet ist, eine Validität der Prüfergebnisse auf Basis eines Vergleichs mit den Testmustern (TM) zu ermitteln und Validierungsergebnisse zu erzeugen.

2. Infrastrukturseitiges Verkehrsüberwachungssystem (20, 30, 50) nach Anspruch 1,
wobei die Validierungseinheit (4) eine Lichtsignaldatenschnittstelle aufweist zum Empfangen von Signaldaten von einer Lichtsignaleinheit (LSA, LSA1, LSA2, LSA3).

3. Infrastrukturseitiges Verkehrsüberwachungssystem (20, 30, 50) nach Anspruch 1 oder 2, wobei die Prüfungseinrichtung (3) eine Parametrisierungseinheit (3e) umfasst, welche dazu eingerichtet ist, Prüfparameter der Prüfeinheiten (3a, 3b, 3c, 3d) bereitzustellen.

4. Infrastrukturseitiges Verkehrsüberwachungssystem (20, 30, 50) nach einem der Ansprüche 1 bis 3, wobei die Testeinheit (2) ferner einen Drehspiegel (SP) umfasst, welcher dazu eingerichtet ist, ein von der Testeinheit (2) erzeugtes Testmuster auf die Sensoren (S1, S2) zu projizieren.

5. Infrastrukturseitiges Verkehrsüberwachungssystem (20, 30, 50) nach einem der Ansprüche 1 bis 4, wobei die Testeinheit (2) eine virtuelle Sensoreinheit (VS) umfasst, welche dazu eingerichtet ist, auf Basis eines Testmusters virtuelle Sensordaten zu erzeugen und der Prüfeinrichtung (3) und der Validierungseinrichtung (4) bereitzustellen.

6. Autonomes Transportsystem (40), aufweisend:
- mindestens ein zumindest teilautonom gesteuertes Fahrzeug (40a),
- ein infrastrukturseitiges Verkehrsüberwachungssystem (20, 30, 50) nach einem der Ansprüche 1 bis 5,
wobei das infrastrukturseitiges Verkehrsüberwachungssystem eine Kommunikationseinheit (5) aufweist,
und wobei das zumindest teilautonom gesteuerte Fahrzeug (40a) dazu eingerichtet ist, von dem infrastrukturseitigen Verkehrsüberwachungssystem (20, 30, 40) erzeugte fusionierte Sensordaten einer Verkehrszelle (10) in der sich das Fahrzeug (40a) bewegt, Prüfergebnisse sowie Validierungsergebnisse zu empfangen und auf Basis dieser Daten eine zumindest teilautonome Steuerung durchzuführen, wobei eine Sicherheitsanforderungsstufe ermittelt wird und das Verhalten des Fahrzeugs an die Sicherheitsanforderungsstufe angepasst wird.

7. Autonomes Transportsystem (40) nach Anspruch 6, aufweisend mindestens eine Lichtsignalanlageneinheit (LSA, LSA1, LSA2, LSA3), welche mit dem infrastrukturseitigen Verkehrsüberwachungssystem (20, 30, 50) über einen Kommunikationskanal verbunden ist und dazu eingerichtet ist, dem infrastrukturseitigen Verkehrsüberwachungssystem (20, 30, 50) Informationen über den aktuellen Signalzustand der Lichtsignalanlageneinheit (LSA, LSA1, LSA2, LSA3) zu übermitteln.

8. Verfahren zur Validierung einer Prüfung von Sensordaten,
ausgeführt durch ein infrastrukturseitiges Verkehrsüberwachungssystem
nach einem der Ansprüche 1 bis 5, aufweisend die Schritte:
- Ausspielen von Testmustern (TM) zur Simulation von Sensordaten,
- Empfangen von fusionierten simulierten Sensordaten,
- Empfangen von Prüfergebnissen, welche auf Basis der fusionierten simulierten Sensordaten erzeugt werden,
- Empfangen der ausgespielten Testmuster (TM),
- Ermitteln einer Validität der Prüfergebnisse auf Basis eines Vergleichs mit den Testmustern (TM).

9. Computerprogrammprodukt mit einem Computerprogramm, welches direkt in eine Speichereinheit eines autonomen Transportsystems (40) nach einem der Ansprüche 6 oder 7 ladbar ist, mit Programmabschnitten, um alle Schritte eines Verfahrens nach Anspruch 8 auszuführen, wenn das Computerprogramm in dem Transportsystem (40) ausgeführt wird.

10. Computerlesbares Medium, auf welchem von einer Rechnereinheit ausführbare Programmabschnitte gespeichert sind, um alle Schritte des Verfahrens nach Anspruch 8 auszuführen, wenn die Programmabschnitte von der Rechnereinheit ausgeführt werden.

## Claims

1. Infrastructure-side traffic monitoring system (20, 30, 50), comprising:
- a plurality of sensor units (S1, S2) for capturing sensor data from a traffic cell (10),
- a sensor fusion unit (1) for the fusion of sensor data,
- a checking device (3) for checking the correctness of fused sensor data, wherein the checking device (3) is designed to receive fused sensor data from the sensor fusion unit (1) and to carry out a consistency check of the sensor data on the basis of the fused sensor data and to output check results, wherein the checking device (3) comprises at least one of the following checking units:
- a redundancy checking unit (3a) for checking whether objects are detected by different sensors with a predefined temporal and spatial tolerance,
- a sequence checking unit (3b) for checking whether a detected movement proceeds in conformity with predetermined criteria,
- a shading checking unit (3c) for checking whether a detected object is shaded by another object,
- a validation device comprising:
- a test unit (2) for outputting test patterns (TM) for simulating sensor data, wherein a test pattern comprises simulated sensor data, - a validation unit (4) having
- a fusion data interface for receiving fused simulated sensor data from the sensor fusion unit (1),
- a check data interface for receiving check results generated by the checking device (3) on the basis of the fused simulated sensor data,
- a test pattern interface for receiving the test patterns (TM) output from the test unit (2),
wherein the test unit (2) is designed to transmit the simulated sensor data to the sensor fusion unit (1), which is configured to generate therefrom fused simulated sensor data and to transmit them to the checking device (3), which is configured to process the fused simulated sensor data and to generate associated check results,
wherein the validation device is configured to determine a validity of the check results on the basis of a comparison with the test patterns (TM) and to generate validation results.

2. Infrastructure-side traffic monitoring system (20, 30, 50) according to Claim 1, wherein the validation unit (4) has a light signal data interface for receiving signal data from a light signal unit (LSA, LSA1, LSA2, LSA3).

3. Infrastructure-side traffic monitoring system (20, 30, 50) according to Claim 1 or 2, wherein the checking device (3) comprises a parameterization unit (3e) configured to provide check parameters of the checking units (3a, 3b, 3c, 3d).

4. Infrastructure-side traffic monitoring system (20, 30, 50) according to any of Claims 1 to 3, wherein the test unit (2) furthermore comprises a rotary mirror (SP) configured to project a test pattern generated by the test unit (2) onto the sensors (S1, S2).

5. Infrastructure-side traffic monitoring system (20, 30, 50) according to any of Claims 1 to 4, wherein the test unit (2) comprises a virtual sensor unit (VS) configured to generate virtual sensor data on the basis of a test pattern and to provide them to the checking device (3) and the validation device (4).

6. Autonomous transport system (40), comprising:
- at least one at least partially autonomously controlled vehicle (40a),
- an infrastructure-side traffic monitoring system (20, 30, 50) according to any of Claims 1 to 5,
wherein the infrastructure-side traffic monitoring system comprises a communication unit (5),
and wherein the at least partially autonomously controlled vehicle (40a) is configured to receive the following generated by the infrastructure-side traffic monitoring system (20, 30, 40): fused sensor data of a traffic cell (10) in which the vehicle (40a) moves, check results and validation results, and to carry out at least partially autonomous control on the basis of these data, wherein a safety requirement level is determined and the behaviour of the vehicle is adapted to the safety requirement level.

7. Autonomous transport system (40) according to Claim 6, comprising at least one light signalling system unit (LSA, LSA1, LSA2, LSA3) which is connected to the infrastructure-side traffic monitoring system (20, 30, 50) via a communication channel and is configured to transmit to the infrastructure-side traffic monitoring system (20, 30, 50) information about the current signal state of the light signalling system unit (LSA, LSA1, LSA2, LSA3).

8. Method for validating a check of sensor data, carried out by an infrastructure-side traffic monitoring system according to any of Claims 1 to 5, comprising the following steps:
- outputting test patterns (TM) for simulating sensor data,
- receiving fused simulated sensor data,
- receiving check results generated on the basis of the fused simulated sensor data,
- receiving the test patterns (TM) output,
- determining a validity of the check results on the basis of a comparison with the test patterns (TM).

9. Computer program product comprising a computer program which is loadable directly into a storage unit of an autonomous transport system (40) according to either of Claims 6 and 7, comprising program sections for carrying out all the steps of a method according to Claim 8 when the computer program is executed in the transport system (40).

10. Computer-readable medium on which program sections are stored which are executable by a computer unit for carrying out all the steps of the method according to Claim 8 when the program sections are executed by the computer unit.

## Revendications

1. Système de surveillance du trafic (20, 30, 50) côté infrastructure, présentant :
- une pluralité d'unités de capteur (S1, S2) pour détecter des données de capteur d'une cellule de trafic (10),
- une unité de fusion de capteur (1) pour fusionner des données de capteur,
- un dispositif de contrôle (3) pour contrôler l'exactitude des données de capteur fusionnées, le dispositif de contrôle (3) étant réalisé pour recevoir des données de capteur fusionnées de l'unité de fusion de capteur (1) et pour effectuer sur la base des données de capteur fusionnées un contrôle de cohérence des données de capteur et pour sortir des résultats de contrôle, le dispositif de contrôle (3) comprenant au moins l'une des unités de contrôle suivantes :
- une unité de contrôle de redondance (3a) pour contrôler si des objets pourvus de différents capteurs sont détectés avec une tolérance temporelle et spatiale prédéfinie,
- une unité de contrôle de séquence (3b) pour contrôler si un mouvement détecté se déroule conformément à des critères prédéterminés,
- une unité de contrôle d'ombre portée (3c) pour contrôler si un objet détecté subit une ombre portée d'un autre objet,
- un dispositif de validation, présentant :
- une unité de test (2) pour passer en revue des motifs de test (TM) pour simuler des données de capteur, un motif de test comprenant des données de capteur simulées,- une unité de validation (4) comprenant
- une interface de données fusionnées pour recevoir des données de capteur simulées fusionnées de l'unité de fusion de capteur (1),
- une interface de données de contrôle pour recevoir des résultats de contrôle qui sont générés par le dispositif de contrôle (3) sur la base des données de capteur simulées fusionnées,
- une interface de motif de test pour recevoir de l'unité de test (2) les motifs de test (TM) passés en revue,
dans lequel l'unité de test (2) est réalisée pour transmettre les données de capteur simulées à l'unité de fusion de capteur (1) qui est conçue pour générer à partir de celles-ci des données de capteur simulées fusionnées et pour les transmettre au dispositif de contrôle (3) qui est conçu pour traiter les données de capteur simulées fusionnées et pour générer des résultats de contrôle associés,
dans lequel le dispositif de validation est conçu pour établir une validité des résultats de contrôle sur la base d'une comparaison avec les motifs de test (TM) et pour générer des résultats de validation.

2. Système de surveillance du trafic (20, 30, 50) côté infrastructure selon la revendication 1,
dans lequel l'unité de validation (4) présente une interface de données de signal lumineux pour recevoir des données de signal d'une unité de feux de signalisation (LSA, LSA1, LSA2, LSA3).

3. Système de surveillance du trafic (20, 30, 50) côté infrastructure selon la revendication 1 ou 2, dans lequel le dispositif de contrôle (3) comprend une unité de paramétrage (3e) qui est conçue pour fournir des paramètres de contrôle des unités de contrôle (3a, 3b, 3c, 3d).

4. Système de surveillance du trafic (20, 30, 50) côté infrastructure selon l'une quelconque des revendications 1 à 3, dans lequel l'unité de test (2) comprend en outre un miroir rotatif (SP) qui est conçu pour projeter sur les capteurs (S1, S2) un motif de test généré par l'unité de test (2).

5. Système de surveillance du trafic (20, 30, 50) selon l'une quelconque des revendications 1 à 4, dans lequel l'unité de test (2) comprend une unité de capteur virtuelle (VS) qui est conçue pour générer des données de capteur virtuelles sur la base d'un motif de test et pour les fournir au dispositif de contrôle (3) et au dispositif de validation (4).

6. Système de transport autonome (40), présentant :
- au moins un véhicule (40a) commandé de manière au moins partiellement autonome,
- un système de surveillance du trafic (20, 30, 50) côté infrastructure selon l'une quelconque des revendications 1 à 5,
dans lequel le système de surveillance du trafic côté infrastructure présente une unité de communication (5),
et dans lequel le véhicule (40a) commandé de manière au moins partiellement autonome est conçu pour recevoir des données de capteur fusionnées, générées par le système de surveillance du trafic (20, 30, 40) côté infrastructure, d'une cellule de trafic (10) dans laquelle se déplace le véhicule (40a), des résultats de contrôle ainsi que des résultats de validation et pour effectuer une commande au moins partiellement autonome sur la base de ces données, dans lequel un niveau d'exigence de sécurité est établi et le comportement du véhicule est adapté au niveau d'exigence de sécurité.

7. Système de transport autonome (40) selon la revendication 6, présentant au moins une unité de feux de signalisation (LSA, LSA1, LSA2, LSA3) qui est reliée au système de surveillance du trafic (20, 30, 50) côté infrastructure par l'intermédiaire d'un canal de communication et est conçue pour transmettre au système de surveillance du trafic (20, 30, 50) côté infrastructure des informations concernant l'état de signal actuel de l'unité de feux de signalisation (LSA, LSA1, LSA2, LSA3).

8. Procédé permettant de valider un contrôle de données de capteur, exécuté par un système de surveillance du trafic côté infrastructure selon l'une quelconque des revendications 1 à 5, présentant les étapes consistant à :
- passer en revue des motifs de test (TM) pour simuler des données de capteur,
- recevoir des simulées fusionnées,
- recevoir des résultats de contrôle qui sont générés sur la base des données de capteur simulées fusionnées,
- recevoir les motifs de test (TM) passés en revue,
- établir une validité des résultats de contrôle sur la base d'une comparaison avec les motifs de test (TM).

9. Produit de programme informatique comprenant un programme informatique qui peut être chargé directement dans une unité de mémoire d'un système de transport autonome (40) selon l'une quelconque des revendications 6 ou 7, avec des parties de programme pour exécuter toutes les étapes d'un procédé selon la revendication 8 lorsque le programme informatique est exécuté dans le système de transport (40).

10. Support lisible par ordinateur, sur lequel sont stockées des parties de programme pouvant être exécutées par une unité de calcul afin d'exécuter toutes les étapes du procédé selon la revendication 8 lorsque les parties de programme sont exécutées par l'unité de calcul.
